# EUROPEAN PATENT APPLICATION

(11) **EP 3 174 060 A1**
(43) Date of publication of application: **31.05.2017**
(21) Application number: 15824066.3
(22) Date of filing: 17.03.2015
(51) Int. Cl.: G11C 7/16, G10L 21/00

(54) **METHOD AND APPARATUS FOR AUDIO MIXING AND PLAYING**

(30) Priority: 25.07.2014 CN 201410362379
(71) Applicant: ZTE Corporation, Shenzhen, Guangdong 518057 (CN)
(72) Inventor: ZHOU, Maolin, Shenzhen Guangdong 518057 (CN)
(74) Representative: Savi, Massimiliano
(86) International application number: PCT/CN2015/074424
(87) International publication number: WO 2016/011814

(57) **Abstract**

A method and apparatus for audio mixing and playing are disclosed. The method includes: receiving at least two audio data streams (S102); decoding the at least two audio data streams (S104); and sending at least two decoded audio data streams to an Audio system of an Android system for audio mixing and playing (S106).

## Description

### Technical Field

The present invention relates to the field of communications, and specifically to a method and apparatus for audio mixing and playing.

### Background

Audio mixing is mainly a processing process of mixing various sound sources such as dialogue, music and sound effect and so on. In short, two-channel or multi-channel audios are mixed and then output. A mobile phone supports sending a keypad tone or receiving a ring when listening to music; and not only the background music can be heard but also the sound of key operation can be heard when playing games. These scenes are all required to perform audio mixing on the audios before the output.

Now there is also a large number of music players based on the Android system. But all these audio players basically support playing of a single audio file or webcasting of a single audio, but they do not support the playing and output of multi-channel music.

At present, the audio playing of the Android operating system mainly uses two approaches, one is an implementation approach of the SoundPool type, and the other is an implementation approach of the MediaPlayer type. The SoundPool is applicable to sounds with high response speed, generally the playing of the sound effect may use the SoundPool approach; and the common music playing uses the MediaPlayer approach. However, if the implementation approach of the SoundPool type is adopted, it is required to firstly load the audio file to a fixed catalogue and it does not support the streaming dynamic downloading and updating, meanwhile there are also requirements for the file size, and the oversize will cause a failed load. If the implementation approach of the MediaPlayer type is adopted, the webcasting may be supported, but the timeliness cannot be guaranteed. Generally this will be adopted in the music players, but the time delay will be larger.

If there are network servers for both two audios, and information of the audio and sound effect cannot be known in advance, and there is a high requirement on the audio timeliness in the meantime, such as games with dynamic update of the audio and sound effect network, both of the above two approaches cannot meet the demands.

With respect to the problem of lacking an audio mixing and playing scheme with higher requirements on the timeliness in the related art, no effective solution has been proposed at present.

### Summary

The embodiments of the present invention provide a method and apparatus for audio mixing and playing, to at least solve the problem of lacking an audio mixing and playing scheme with higher requirements on the timeliness in the related art.

According to one embodiment of the present invention, a method for audio mixing and playing is provided, which includes: receiving at least two audio data streams; decoding the at least two audio data streams; and sending at least two decoded audio data streams to an Audio system of an Android system for audio mixing and playing.

In the embodiment, decoding the at least two audio data streams includes: parsing audio formats of the at least two audio data streams; and respectively decoding the at least two audio data streams into PCM formats according to audio parameters corresponding to the audio formats.

In the embodiment, the audio parameters corresponding to the audio formats include at least one of the following: audio parameters corresponding to a TS format include an audio type and an audio packet ID, PID; audio parameters corresponding to a WAV format include a sampling rate, a sampling precision and a sound channel mode; and audio parameters corresponding to a MP3 format include a sampling frequency, a bit rate, a sound channel mode and version information.

In the embodiment, sending at least two decoded audio data streams to an Audio system of an Android system for audio mixing includes: injecting the at least two decoded audio data streams into the Audio system via an interface of an AudioTrack module.

In the embodiment, receiving at least two audio data streams includes: receiving the at least two audio data streams from an audio stream server of a network side.

In the embodiment, the way of receiving the at least two audio data streams from an audio stream server of a network side includes at least one of the following: receiving the at least two audio data streams from the audio stream server of the network side through a transmission control protocol, TCP, link; and receiving the at least two audio data streams from the audio stream server of the network side through a hypertext transfer protocol, HTTP, link.

According to another embodiment of the present invention, an apparatus for audio mixing and playing is further provided, which includes: a receiving module, arranged to receive at least two audio data streams; a decoding module, arranged to decode the at least two audio data streams; and an audio mixing and playing module, arranged to send at least two decoded audio data streams to an Audio system of an Android system for audio mixing and playing.

In the embodiment, the decoding module includes: a parsing unit, arranged to parse audio formats of the at least two audio data streams; and a decoding unit, arranged to respectively decode the at least two audio data streams into PCM formats according to audio parameters corresponding to the audio formats.

In the embodiment, the audio mixing and playing module includes: an injection unit, arranged to inject the at least two decoded audio data streams into the Audio system via an interface of an AudioTrack module.

In the embodiment, the receiving module includes: a receiving unit, arranged to receive the at least two audio data streams from an audio stream server of a network side.

Through the embodiments of the present invention, by means of receiving at least two audio data streams; decoding the at least two audio data streams; and sending at least two decoded audio data streams to an Audio system of an Android system for audio mixing and playing, the problem of lacking an audio mixing and playing scheme with higher requirements on the timeliness in the related art is solved, which improves the timeliness of the audio mixing and playing and may get rid of constraints on the file size in the meantime.

### Brief Description of Drawings

The accompanying drawings described here are used to provide a further understanding of the present invention and constitute a part of the present invention. The exemplary embodiments and illustrations thereof of the present invention are used to explain the present invention, but do not constitute an inappropriate limitation on the present invention. In the drawings:
FIG. 1 is a flow chart of a method for audio mixing and playing according to an embodiment of the present invention.
FIG. 2 is a structure diagram of an apparatus for audio mixing and playing according to an embodiment of the present invention.
FIG. 3 is a schematic diagram of a flow of mixing two audios according to a preferred embodiment 1 of the present invention.
FIG. 4 is a schematic diagram of an audio mixing flow of audio and sound effects of local games according to a preferred embodiment 2 of the present invention.
FIG. 5 is a schematic diagram of an audio mixing and playing flow of Karaoke software according to a preferred embodiment 3 of the present invention.

### Specific Embodiments

The present invention will be described in detail with reference to the accompanying drawings and in combination with the embodiments below. It should be noted that the embodiments in the present invention and the characteristics in the embodiments can be combined with each other in the case of no conflicts.

The embodiment provides an implementation way for audio mixing based on an Android operating system, which may not only guarantee the timeliness but also get rid of constraints on the file size and perform dynamic downloading and updating.

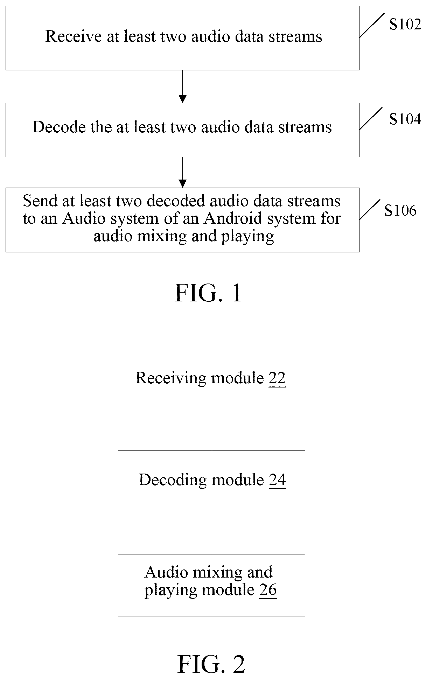

In the embodiment, a method for audio mixing and playing is provided. FIG. 1 is a flow chart of a method for audio mixing and playing according to an embodiment of the present invention, and the method includes the following steps as shown in FIG. 1.

In step S102, at least two audio data streams are received.

In step S104, the at least two audio data streams are decoded.

In step S106, at least two decoded audio data streams are sent to an Audio system of an Android system for audio mixing and playing.

In the embodiment, through the above steps, the received multiple audio data streams are decoded and then sent to the Audio system of the Android system for audio mixing and playing so as to implement the direct audio mixing and playing of the audio data streams, which solves the problem of lacking an audio mixing and playing scheme with higher requirements on the timeliness in the related art, improves the timeliness of the audio mixing and playing and may get rid of constraints on the file size in the meantime.

As a preferred embodiment, decoding the at least two audio data streams may specifically include: parsing audio formats of the at least two audio data streams; and respectively decoding the at least two audio data streams into Pulse Code Modulation (PCM) formats according to audio parameters corresponding to the audio formats.

Alternatively, the audio parameters corresponding to the audio formats include at least one of the following: audio parameters corresponding to a TS format include an audio type and an audio Packet ID (PID); audio parameters corresponding to a WAV format include a sampling rate, a sampling precision and a sound channel mode; and audio parameters corresponding to an MP3 format include a sampling frequency, a bit rate, a sound channel mode and version information.

Alternatively, the at least two decoded audio data streams may be injected into the Audio system via an interface of an AudioTrack module.

Alternatively, the received at least two audio data streams may be sent from an audio stream server of a network side. Herein, the way of receiving the at least two audio data streams from the audio stream server of the network side may be receiving the at least two audio data streams from the audio stream server of the network side through a Transmission Control Protocol (TCP) link; or it may be receiving the at least two audio data streams from the audio stream server of the network side through a Hypertext transfer protocol (HTTP) link.

Corresponding to the above method for audio mixing and playing, an apparatus for audio mixing and playing is also provided in the embodiment, and the apparatus is arranged to implement the above embodiments and preferred embodiments, and what have been described will not be repeated. For example, a term "module" used below may be a combination of software and/or hardware for implementing preset functions. Though the apparatus described in the following embodiments is preferentially implemented by software, an implementation by hardware or a combination of software and hardware is also possible and conceived.

FIG. 2 is a structure diagram of an apparatus for audio mixing and playing according to an embodiment of the present invention, and the apparatus includes a receiving module 22, a decoding module 24 and an audio mixing and playing module 26 as shown in FIG. 2, and various modules will be described in detail below.

The receiving module 22 is arranged to receive at least two audio data streams; the decoding module 24 connected to the receiving module 22 is arranged to decode the at least two audio data streams received by the receiving module 22; and the audio mixing and playing module 26 connected to the decoding module 24 is arranged to send at least two audio data streams decoded by the decoding module 24 to an Audio system of an Android system for audio mixing and playing.

Alternatively, the decoding module 24 may include: a parsing unit, arranged to parse audio formats of the at least two audio data streams; and a decoding unit, arranged to respectively decode the at least two audio data streams into PCM formats according to audio parameters corresponding to the audio formats.

Alternatively, the audio mixing and playing module 26 may include: an injection unit, arranged to inject the at least two decoded audio data streams into the Audio system via an interface of an AudioTrack module.

Alternatively, the receiving module 22 may include: a receiving unit, arranged to receive the at least two audio data streams from an audio stream server of a network side.

Descriptions will be made in combination with preferred embodiments below, and the following preferred embodiments are combined with the above embodiments and preferred embodiments thereof.

In the following preferred embodiments, a method for audio mixing and playing based on the Android system, especially a way of supporting network streaming transmission and audio playing, is provided.

The method for audio mixing and playing based on the Android relates to an audio server and a mix player. The audio server is arranged to send audios to the mix player in real time through network transmission; and the mix player using an Android operating system is arranged to receive audio streams transmitted by the network audio server, parse audio parameters, and perform decoding and audio mixing and then play and output.

The method for audio mixing and playing based on the Android is mainly implemented through the following steps.

In step S2, an audio server sends audios to a mix player.

In step S4, the mix player parses audio formats after receiving the audios.

In step S6, the mix player starts audio decoding and sends the decoded data to an Audio system of the Android.

In step S8, the Audio system of the Android mixes two or more than two audios to play and output.

The audio player based on the Android here may be a network play box, or a set-top box, or a mobile phone or a computer device, which will not be limited in form.

With the above method of the preferred embodiment, the audios transmitted by multiple channels of networks may be simultaneously mixed and output, which may not only guarantee the timeliness, but also get rid of constraints on the file size and perform dynamic downloading and updating.

### Preferred embodiment 1

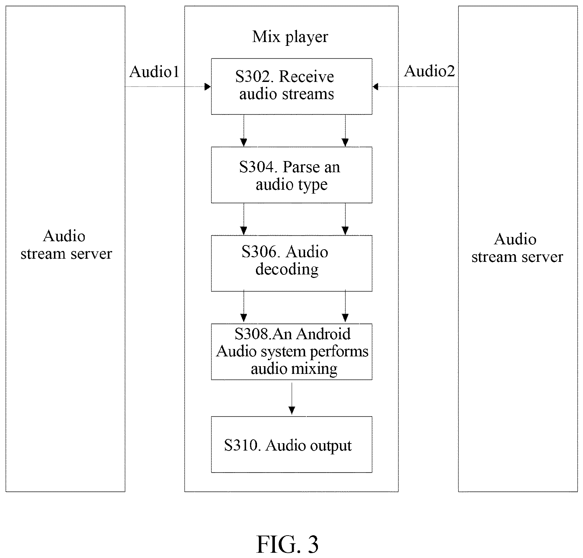

FIG. 3 is a schematic diagram of a flow of mixing two audios according to a preferred embodiment 1 of the present invention, and as shown in FIG. 3, the implementation flow of the technical scheme of mixing the two audios will be described in detail as follows.

In step S302, a mix player receives audio data sent by an audio server.

The audios sent by the audio stream server are in an MP3 format, a WAV format and a TS format and so on. The transmission mode may be directly a Transmission Control Protocol (TCP) or may be transmitting by means of Hypertext transfer protocol (HTTP).

In step S304, the mix player parses audio formats after receiving audio streams.

Different audio formats have different audio parameters, for example, the TS mode includes an audio type and an audio PID and the like; the WAV includes a sampling rate, a sampling precision and a sound channel mode and the like; and the MP3 includes a sampling frequency, a bit rate, a sound channel mode and version information and the like.

In step S306, the mix player starts audio decoding.

If it is directly a PCM format, decoding is not required.

In step S308, the decoded audio PCM data are sent to an Audio system of the Android, and the Audio system of the Android may perform audio mixing.

For the audio mixing of the Audio system here, the injection of the audios may be implemented via an interface of an AudioTrack module.

In step S310, the Audio system of the Android outputs two or more than two audios.

For the injection of two channels of Audiotrack, the bottom layer of the Android system will call submodules such as an Audio Mixer and an Audio Resampler to implement audio mixing and output.

### Preferred embodiment 2

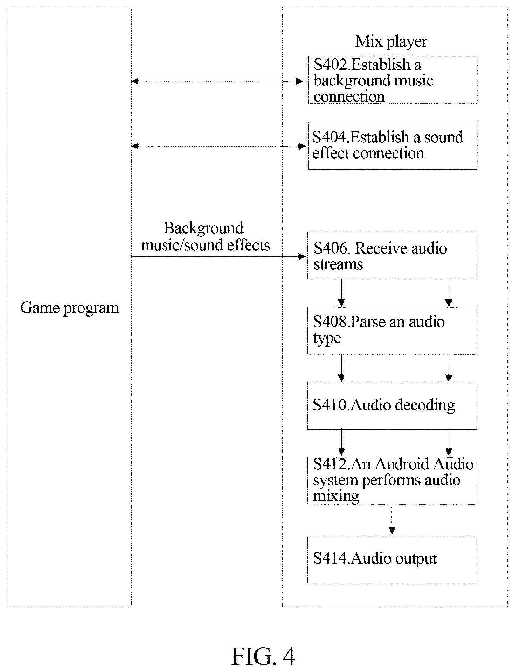

FIG. 4 is a schematic diagram of an audio mixing flow of audio and sound effects of local games according to a preferred embodiment 2 of the present invention, and as shown in FIG. 4, the implementation flow of the scheme of mixing the audio and sound effects of the games will be described in detail as follows.

With respect to the network games, background music files and sound effect files are all in the network server, a game program needs to be dynamically downloaded and updated for playing, and in the audio mixing scheme, establishing a way of long connection between the audio player and the game program for playing is considered.

In step S402, a mix player establishes a long connection of TCP established with the game program to transmit the background music.

In step S404, the mix player establishes a long connection of TCP established with the game program to transmit the sound effects.

Furthermore, the foresaid two steps are in no particular order, the long connection approach of the TCP may also be changed into the HTTP approach for implementation.

In step S406, the mix player receives audio/sound effect data sent by the game program.

Furthermore, when the games have no actions like key pressing, the games may send mute data to the player; and the mute data refer to the played audio data without sounds.

In step S408, the mix player parses audio formats after receiving audio streams.

Different audio formats have different audio parameters, for example, the TS mode includes an audio type and an audio PID and the like; the WAV includes a sampling rate, a sampling precision and a sound channel mode and the like; and the MP3 includes a sampling frequency, a bit rate, a sound channel mode and version information and the like.

Furthermore, if the pre-and-post formats received by the mix player are different, it is required to restart audio decoding and audio mixing.

In step S410, the mix player starts audio decoding.

If it is a PCM format, decoding is not required.

In step S412, the decoded audio PCM data are sent to an Audio system of the Android, and the Audio system of the Android may perform audio mixing.

Similar to the preferred embodiment 1, for the audio mixing of the Audio system here, the injection of the audios may be implemented via an interface of an AudioTrack module.

In step S414, the Audio system of the Android mixes and outputs two or more than two audios.

In this way, the game program updates the audio and sound effects and then it may be promptly output via the mix player.

### Preferred embodiment 3

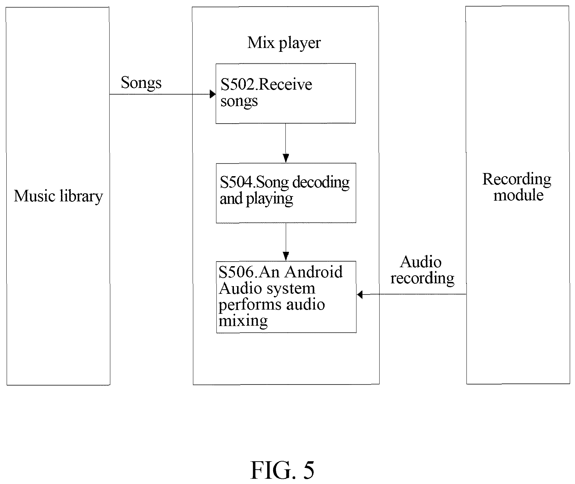

FIG. 5 is a schematic diagram of an audio mixing and playing flow of Karaoke software according to a preferred embodiment 3 of the present invention, and as shown in FIG. 5, the implementation flow of the Android Karaoke playing scheme will be described in detail as follows, and the Karaoke playing scheme here does not describe an audio recording module scheme in detail.

In step S502, a mix player acquires audio data of related songs from a music library.

In step S504, the mix player performs decoding and sends to an Android Audio system to output.

Similar to the preferred embodiment 1, for the audio mixing of the Audio system here, the injection of the audios may be implemented via an interface of an AudioTrack module, and the parsing and playing flow is also similar to the preferred embodiment 2.

In step S506, a recording module directly sends the audio data to the mix player; and the mix player directly uses the Android Audio system to perform audio mixing and output.

Generally speaking, what the recording module of the Android records is a PCM audio format, thus the audio decoding is not required.

The above embodiment only describes the example of the audio mixing and playing scheme, the audio server or the mix player is not limited to the above forms.

In another embodiment, software is also provided, and the software is arranged to execute the technical scheme described in the above embodiments and preferred embodiments.

In another embodiment, a storage medium is also provided, the above software is stored in the storage medium, and the storage medium includes but is not limited to an optical disk, a floppy disk, a hard disk and an erasable memory, etc.

Apparently, the people skilled in the art should understand that the modules or steps of the present invention mentioned above may be implemented through a universal calculating apparatus, and they may be concentrated on a single calculating apparatus or distributed in a network composed of a plurality of calculating apparatuses. Alternatively, the modules or steps may be implemented through program codes that can be executed by the calculating apparatus, thus, they can be stored in the storage apparatus to be executed by the calculating apparatus, and in some cases, the illustrated or described steps may be executed in a sequence different from here, or they may be made into various integrated circuit modules respectively, or a plurality of modules or steps of them may be made into a single integrated circuit module to be implemented. Therefore, the present invention is not limited to any combination of hardware and software in a specific form.

The above description is only the preferred embodiments of the present invention, which is not used to limit the present invention. The present invention may have various modifications and changes for the people skilled in the art. All the modifications, equivalent substitutions, and improvements, etc. made within the spirit and principle of the present invention shall be contained within the protection scope of the present invention.

### Industrial Applicability

As mentioned above, a method and apparatus for audio mixing and playing provided in the embodiments of the present invention have the following beneficial effects: the problem of lacking an audio mixing and playing scheme with higher requirements on the timeliness in the related art is solved, which improves the timeliness of the audio mixing and playing and may get rid of constraints on the file size in the meantime.

## Claims

1. A method for audio mixing and playing, comprising:
receiving at least two audio data streams;
decoding the at least two audio data streams; and
sending at least two decoded audio data streams to an Audio system of an Android system for audio mixing and playing.

2. The method according to claim 1, wherein, decoding the at least two audio data streams comprises:
parsing audio formats of the at least two audio data streams; and
respectively decoding the at least two audio data streams into PCM formats according to audio parameters corresponding to the audio formats.

3. The method according to claim 2, wherein, the audio parameters corresponding to the audio formats comprise at least one of the following:
audio parameters corresponding to a TS format comprise an audio type and an audio packet ID, PID;
audio parameters corresponding to a WAV format comprise a sampling rate, a sampling precision and a sound channel mode; and
audio parameters corresponding to a MP3 format comprise a sampling frequency, a bit rate, a sound channel mode and version information.

4. The method according to claim 1, wherein, sending at least two decoded audio data streams to an Audio system of an Android system for audio mixing comprises:
injecting the at least two decoded audio data streams into the Audio system via an interface of an AudioTrack module.

5. The method according to claim 1, wherein, receiving at least two audio data streams comprises:
receiving the at least two audio data streams from an audio stream server of a network side.

6. The method according to claim 5, wherein, the way of receiving the at least two audio data streams from an audio stream server of a network side comprises at least one of the following:
receiving the at least two audio data streams from the audio stream server of the network side through a transmission control protocol, TCP, link; and
receiving the at least two audio data streams from the audio stream server of the network side through a hypertext transfer protocol, HTTP, link.

7. An apparatus for audio mixing and playing, comprising:
a receiving module, arranged to receive at least two audio data streams;
a decoding module, arranged to decode the at least two audio data streams; and
an audio mixing and playing module, arranged to send at least two decoded audio data streams to an Audio system of an Android system for audio mixing and playing.

8. The apparatus according to claim 7, wherein, the decoding module comprises:
a parsing unit, arranged to parse audio formats of the at least two audio data streams; and
a decoding unit, arranged to respectively decode the at least two audio data streams into PCM formats according to audio parameters corresponding to the audio formats.

9. The apparatus according to claim 7, wherein, the audio mixing and playing module comprises:
an injection unit, arranged to inject the at least two decoded audio data streams into the Audio system via an interface of an AudioTrack module.

10. The apparatus according to claim 7, wherein, the receiving module comprises:
a receiving unit, arranged to receive the at least two audio data streams from an audio stream server of a network side.
